# EUROPÄISCHE PATENTSCHRIFT

(11) **EP 1 780 307 B1**
(45) Veröffentlichungstag und Bekanntmachung des Hinweises auf die Patenterteilung: **14.01.2015**
(21) Anmeldenummer: 06019707.6
(22) Anmeldetag: 20.09.2006
(51) Int. Cl.: C23C 26/00, B29C 33/58, C09D 7/12, C30B 35/00, C03C 17/22

(54) **Dauerhafte siliciumnitridhaltige Hartbeschichtung**
Permanent hard coating comprising silicon
Revêtement durable comprenant du silicium

(30) Priorität: 21.10.2005 DE 102005050593
(43) Veröffentlichungstag der Anmeldung: 02.05.2007
(73) Patentinhaber: ESK Ceramics GmbH & Co.KG, 87437 Kempten (DE)
(72) Erfinder: Engler Martin, Dr., 87439 Kempten (DE); Lesniak Christoph Dr., 87474 Buchenberg (DE); Uibel Krishna, 87435 Kempten (DE)
(74) Vertreter: Ter Meer Steinmeister & Partner

(56) Entgegenhaltungen:
- WO-A-99/57077
- WO-A-2004/053207
- WO-A1-2007/039310
- DE-A1- 10 326 815
- US-A- 4 921 731
- US-A- 5 452 755
- US-A1- 2004 211 496

## Beschreibung

### Gebiet der Erfindung

Die vorliegende Erfindung betrifft eine Schlichte zur Herstellung einer dauerhaften siliciumnitridhaltigen Hartbeschichtung auf einem Substrat, einen Formkörper aus einem Substrat und einer darauf aufgebrachten dauerhaften Hartbeschichtung, welche abrieb- und kratzfest ist, sodass der Formkörper transportabel ist, ein Verfahren zur Herstellung eines solchen Formkörpers sowie die Verwendung solcher Formkörper, insbesondere als Schmelztiegel zur Anwendung im Bereich korrosiver Nichteisenmetallschmelzen, insbesondere im Bereich der Solar-Silicium-Verarbeitung.

### Hintergrund der Erfindung

Zum Erschmelzen und zur Rekristillation von Siliciumbarren aus Siliciumkörnungen, Siliciumgranulaten oder Siliciumstückgut werden Tiegel aus Graphit oder aus Siliciumnitrid, jedoch hauptsächlich aus SiO₂ (fused silica) verwendet. Über exakt definierte Abkühlvorgänge kristallisieren aus der Schmelze Siliciumbarren mit den gewünschten Gefügen und Reinheiten aus, die anschließend zu dünnen Scheiben geschnitten werden und den aktiven Bestandteil von Photovoltaikanlagen bilden.

Wesentlich ist hierbei, dass durch die bei der Verarbeitung verwendeten Materialien, wie Schmelztiegel, die Solar-Silicium-Qualität nicht negativ beeinträchtigt wird und die Siliciumschmelze defektfrei erstarren und unzerstört aus dem Tiegel entformt werden kann. In diesem Zusammenhang ist es wichtig, den korrosiven Angriff von flüssigem Siliciummetall auf das Tiegelmaterial zu verhindern, da die Schmelze sonst verunreinigt würde. Ferner führen Anhaftungen, Infiltration und Diffusion zu Problemen beim Entformen der Siliciumbarren, sodass die Gefahr eines Reißens oder Zerspringens des polykristallinen Siliciumblocks besteht.

Durch die korrosive Siliciumschmelze kommt es zu einem Angriff auf den SiO₂-Tiegel, da zwischen Si und SiO₂ eine chemische Reaktion unter Bildung von flüchtigem SiO stattfindet. Zudem gelangen auf diese Weise unerwünschte Verunreinigungen aus dem Tiegelmaterial in die Siliciumschmelze.

Insbesondere sind Anhaftungen des erstarrenden oder erstarrten Siliciumblocks unter allen Umständen zu vermeiden, da das Silicium sehr große thermische Ausdehnungen durchläuft, wobei kleinste Anhaftungen zu mechanischem Stress und damit zum Bruch der kristallinen Struktur führen, was einen Ausschuss an Siliciummaterial bedeutet.

In der Aluminium-Metallurgie, insbesondere beim Aluminium-Niederdruckguss werden Steigrohre aus Eisenlegierungen oder aus Quarzglas (fused silica) verwendet. Aufgrund der stark korrosiv wirkenden Aluminiumschmelze bei Temperaturen im Bereich von 650 bis 800°C müssen diese Steigrohre in regelmäßigen Abständen mit feuerfesten Oxiden bzw. Nitriden beschichtet werden, um ein zu schnelles Auflösen dieser Werkstoffe im flüssigen Aluminium zu vermeiden. Üblicherweise kommen hierbei Beschichtungen aus Aluminiumoxid oder Bornitrid zum Einsatz, welche aus Schlichten, die organische Bindemittel enthalten, durch Tauchen, Pinseln oder Sprühen aufgebracht werden. Durch den kombinierten korrosiven und mechanischen Angriff durch die heiße Schmelze und die aufschwimmende Schlacke ist die Lebensdauer solcher Beschichtungen jedoch auf Stunden bzw. wenige Tage begrenzt. Alternativ zu den beschichteten Steigrohren aus Eisenlegierung oder Quarz kommen auch Steigrohre aus Siliciumnitrid-Keramik zum Einsatz, welche vollkommen inert gegenüber korrosiven Angriffen durch Aluminiumschmelzen sind. Die Kosten dieser Siliciumnitrid-Rohre sind allerdings um ein vielfaches höher als bei den Standard-Steigrohren mit Beschichtung.

### Stand der Technik

Aus EP 963 464 B 1 sind mit Siliciumnitrid-Schichten versehene Schmelztiegel aus Quarz, Graphit oder Keramik zur Vermeidung von Verklebungen zwischen Schmelztiegel und Nichteisenmetallen nach Kontakt des Schmelztiegels mit erstarrenden Nichteisenmetallschmelzen, wie Siliciumschmelzen, bekannt, wobei die Schichten aus einem Siliciumnitrid-Pulver hoher Reinheit bestehen. Die Siliciumnitrid-Pulver weisen einen niedrigen Sauerstoffgehalt sowie ein bestimmtes Aspektverhältnis auf. Diese Pulverbeschichtungen werden direkt vom Anwender vor dem Einsatz der Schmelztiegel aufgebracht und dadurch hergestellt, dass man hochreines Siliciumnitrid-Pulver in einem Lösungsmittel dispergiert und dann beispielsweise durch Sprühen der Suspension auf die Tiegel aufbringt. Durch thermische Nachbehandlung müssen das Lösungsmittel und gegebenenfalls eingesetzte organische Binderbestandteile entfernt werden. Das hochreine Siliciumnitrid selbst erwies sich als chemisch sehr beständig gegenüber Siliciumschmelzen. Allein durch das Gewicht der Schmelze kommt es jedoch zur Zwangsbenetzung bzw. Infiltration der porösen Siliciumnitrid-Pulverschicht. Diese muss daher in einer solchen Dicke ausgebildet werden, dass sie nicht vollständig infiltriert wird und damit immer noch als Trenn- bzw. Entformungsschicht dienen kann. Entsprechend dicke Schichten sind jedoch wiederum entsprechend weich bzw. nicht besonders abriebfest, sodass beim Beladen der Tiegel besondere Sorgfalt angewendet werden muss, ganz zu Schweigen von langen Transportwegen oder dem Versand gebrauchsfertiger beschichteter Tiegel.

Die herkömmlichen Tiegelbeschichtungen zur Anwendung auf dem Gebiet von Solarsilicium sind somit darin nachteilig, dass die Beschichtungen eine geringe mechanische Stabilität aufweisen, da diese nur aus Siliciumnitrid-Pulver bestehen, sodass die Beschichtungen immer unmittelbar vor der Beladung der Tiegel mit dem Siliciumpulver, -grus oder -stückgut erfolgen müssen. Eine vorausgehende Beschichtung der Tiegel nicht unmittelbar an der Stelle der Verwendung ist somit nicht möglich. Aufgrund der weichen Pulverbeschichtungen muss weiterhin extreme Sorgfalt beim Beladen der Tiegel mit grobem Stückgut angewandt werden, um eine Beschädigung der Schicht zu vermeiden. Weiterhin kommt es aufgrund der Infiltration der porösen Siliciumnitrid-Pulverschicht mit dem schmelzflüssigen Silicium beim Entformen zu unerwünschten Anbackungen.

Die DE 103 26 769 B3 beschreibt dauerhafte Bornitrid-Formtrennschichten für das Druckgießen von Nichteisenmetallen sowie Schlichten zu deren Herstellung, wobei refraktäre nanoskalige Bindemittel als Bindephase für Bornitrid eingesetzt werden. Insbesondere werden Suspensionen aus SiO₂-basiertem Sol-Gel-Binder und Bornitridpulver auf Metall- oder anorganische Nicht-Metalloberflächen aufgebracht und die so erhaltenen Beschichtungen getrocknet und thermisch verdichtet. Bei Temperaturen über 500°C wandelt sich das Bindersystem in eine glasartige Matrix um, die der dabei entstehenden keramischen dichten Schicht mechanische Stabilität verleiht. Auf dem Gebiet der Solar-Silicium-Anwendung können diese bornitridhaltigen Schichten jedoch nicht eingesetzt werden, da Bornitrid als Verunreinigung im Solarsilicium nicht erwünscht ist.

Die DE 103 26 815 A1 beschreibt ein Substrat mit einer antiadhäsiven Beschichtung, erhältlich durch Auftragen einer Beschichtungszusammensetzung auf ein Substrat und Härten, wobei die Beschichtungszusammensetzung a) Festoffteilchen von einem Trennmittel, ausgenommen Bornitrid, und b) ein Bindemittel, umfassend oberflächenmodifizierte nanoskalige Feststoffteilchen, umfasst. Die Trennmittelteilchen werden hierbei ausgewählt aus Graphit, Graphitverbindungen, Metallsulfiden, Metallseleniden und/oder Metalltelluriden. Auch diese Beschichtungen sind für die Solar-Silicium-Anwendung nicht geeignet, da auch die dort genannten Trennmittel, wie Graphit oder Metallsulfide, -selenide und -telluride als Verunreinigungen im Solarsilicium unerwünscht sind.

### Aufgabe der Erfindung

Der Erfindung liegt daher die Aufgabe zugrunde, eine Schlichte zur Herstellung einer dauerhaften Beschichtung auf einem Substrat vorzusehen, welche Beschichtung insbesondere geeignet ist für Anwendungen im Bereich der Solar-Silicium-Verarbeitung, ohne die im Stand der Technik bekannten Nachteile aufzuweisen.

### Zusammenfassung der Erfindung

Die obengenannte Aufgabe wird gelöst durch eine Schlichte zur Herstellung einer dauerhaften Hartbeschichtung gemäß Anspruch 1, einen Formkörper gemäß Anspruch 9, umfassend ein Substrat mit einer dauerhaften Hartbeschichtung, ein Verfahren zur Herstellung eines solchen Formkörpers gemäß Anspruch 12 sowie die Verwendung eines solchen Formkörpers gemäß den Ansprüchen 13 und 14. Vorteilhafte bzw. besonders zweckmäßige Ausgestaltungen des Anmeldungsgegenstandes sind in den Unteransprüchen angegeben.

Gegenstand der Erfindung ist somit eine Schlichte zur Herstellung einer dauerhaften Hartbeschichtung auf einem Substrat, umfassend a) Siliciumnitrid-Partikel, und b) ein Bindemittel, umfassend nanoskalige Feststoffpartikel oder Vorstufen von nanoskaligen Feststoffpartikeln, welche über einen Sol-Gel-Prozess in diese Feststoffpartikel umgewandelt werden, wobei das Bindemittel ein Nanokomposit aus den nanoskaligen Feststoffteilchen in einem organisch modifizierten anorganischen Polykondensat oder einer Vorstufe davon umfasst.

Gegenstand der Erfindung ist weiterhin ein Formkörper, umfassend ein Substrat mit einer dauerhaften Hartbeschichtung, wobei die Hartbeschichtung aus einer wie oben definierten, erfindungsgemäßen Schlichte hergestellt worden ist.

Gegenstand der Erfindung ist weiterhin die Verwendung eines erfindungsgemäßen Formkörpers auf dem Gebiet der korrosiven Nichteisenmetallschmelzen, insbesondere die Verwendung eines Formkörpers in Form eines Schmelztiegels zur Herstellung von Siliciumschmelzen.

Der überraschende Effekt bei den erfindungsgemäßen Siliciumnitrid-Hartbeschichtungen besteht darin, dass hier hart gebundene Siliciumnitrid-Partikel vorliegen, welche die Entformung von erstarrten Nichteisenmetallschmelzen nicht behindern, ohne die Nachteile des porösen und losen Siliciumnitrid-Pulverschichtaufbaus beim Transport und Beladen der mit solchen Hartbeschichtungen versehenen Formkörper aufzuweisen.

Für den Fachmann war es überraschend, dass die aus DE 103 26 769 B3 und DE 103 26 815 A1 bekannten SiO₂-basierten Bindersysteme sich zur Herstellung von dauerhaften Siliciumnitrid-Hartbeschichtungen für die erfindungsgemäß vorgesehenen Anwendungen eignen, da er erwartet hätte, dass die zusätzlichen anorganischen Bindemittel bzw. nanoskaligen Feststoffteilchen die Entformung der erstarrten Nichteisenmetallschmelzen erschweren würden und dass Verunreinigungen in die erstarrten Nichteisenmetallschmelzen, insbesondere Solar-Silicium-Blöcke eingeschleppt werden, was es unter allen Umständen zu vermeiden gilt. Der Fachmann hätte zudem erwartet, dass es bei Verwendung eines SiO₂-basierte Bindersystems ebenfalls zu Reaktionen zwischen dem schmelzflüssigem Silicium und dem SiO₂ des Bindersystems kommt, wie es im System Si-Schmelze und SiO₂-Tiegel der Fall ist. Die Si-Schmelze greift korrosiv das SiO₂-Material an, wobei gasförmiges SiO entsteht, das entweicht und somit weiteres SiO₂ der Si-Schmelze ausgesetzt ist. Die Beschichtung müsste kontinuierlich durch diese Reaktion aufgelöst werden. Diese Reaktion ist beispielsweise aus Cryst. Res. Technol. 38, No. 7-8, 669-675 (2003) bekannt.

Die erfindungsgemäßen Siliciumnitrid-Hartschichten weisen insbesondere folgende Vorteile auf:
- Die Hartschichten sind absolut transportstabil, sodass gebrauchsfertig beschichtete Formkörper, wie Schmelztiegel, an den Endanwender geliefert werden können.
- Die Beschichtungen sind abriebfest und bieten daher Schutz vor Beschädigung beim Beladen der Formkörper, insbesondere beim Beladen von beschichteten Schmelztiegeln mit Roh-Silicium oder auch beim Handtieren mit solchen Formkörpern. Andererseits kommt es bei den herkömmlichen Siliciumnitrid-Pulverbeschichtungen durch Beschädigung der Schutzschicht zu unerwünschten Korrosionserscheinungen und Anhaftungen, was bei den erfindungsgemäßen Hartschichten nicht der Fall ist.
- Die erfindungsgemäßen Hartschichten sind dicht und hochtemperaturstabil, es kommt nicht zur Infiltration durch das schmelzflüssige Nichteisenmetall, wie Silicium, sodass die erstarrten Schmelzen ohne Anhaftungen entformt werden können. Damit entfällt der zusätzliche Schritt der mechanischen Entfernung der Anhaftungen und es entsteht kein oder weniger Ausschuss. Andererseits kommt es bei den herkömmlichen Siliciumnitrid-Pulverschichten nach dem Entformen zu Anhaftungen, da die poröse Siliciumnitrid-Schicht durch das schmelzflüssige Nichteisenmetall, wie Silicium, infiltriert wird. Diese Anhaftungen müssen mechanisch entfernt werden, was einerseits einen zusätzlichen Arbeitsschritt darstellt und andererseits Materialausschuss bedeutet.
- Bei den Schichten gemäß dem Stand der Technik (EP 963 464) besteht das Problem, daß durch die diffusionsoffene Siliciumnitrid-Pulverschicht Verunreinigungen aus dem SiO₂-Tiegel in das Solar-Silicium hineindiffundieren können, weil die Möglichkeit eines Schmelze-Substrat-Kontaktes gegeben ist. Dadurch werden Verunreinigungen in das Solar-Silicium eingeschleppt, was zu erheblichen Qualitätseinbußen und damit zu Ausschuß führt.

Bei den erfindungsgemäßen Schichten besteht ein weiterer Vorteil darin, daß die Schichten aufgrund ihrer dichten Struktur als Diffusionsbarriere für Verunreinigungen wirken, weil sie den direkten Schmelze-Substrat-Kontakt verhindern.

### Detaillierte Beschreibung der Erfindung

Das erfindungsgemäß eingesetzte Bindemittel, welches nanoskalige Feststoffteilchen oder Vorstufen von nanoskaligen Feststoffpartikeln aus der Herstellung über einen Sol-Gel-Prozess umfasst, ist dem Grunde nach aus DE 103 26 815 A1 bekannt. Es hat sich gezeigt, dass die Siliciumnitrid-Partikel mit diesem Bindemittel dauerhaft und temperaturstabil auf Substratoberflächen gebunden werden können. Gemäß der Erfindung wird ein Nanopartikel enthaltendes Nanokomposit, insbesondere in Form eines Sols, als Bindemittel verwendet. Ein Nanokomposit bzw. ein Nanokompositsol besteht aus einer Mischung von nanoskaligen Feststoffteilchen und vorzugsweise nach dem Sol-Gel-Verfahren hergestellten organisch modifizierten, anorganischen Polykondensaten oder Vorstufen davon. In der Beschichtungszusammensetzung liegt das Bindemittel aus Nanopartikeln oder Nanokomposit gewöhnlich als Sol oder Dispersion vor. In der gehärteten Schicht stellt es einen Matrixbildner dar. Durch diesen rein keramischen Aufbau der Schicht werden mehrere Anforderungen gewährleistet. Neben der Hochtemperaturstabilität und der Reinheit der Beschichtung wird die Haftung der Schicht auf dem Substrat und die mechanische Stabilität aufgrund der Härte und Abriebfestigkeit der Schicht gewährleistet.

Bei den nanoskaligen Feststoffteilchen handelt es sich vorzugsweise um Metalloxidteilchen oder solche Systeme, die sich nach Härten durch Hochtemperaturbehandlung in nanoskalige Metalloxidteilchen umwandeln. Insbesondere sind die nanoskaligen Feststoffteilchen aus SiO₂, TiO₂, ZrO₂, Al₂O₃, AIOOH, Y₂O₃, CeO₂, SnO₂, Eisenoxiden und/oder Ta₂O₅ oder aus Vorstufen dieser nanoskaligen Feststoffteilchen, welche über den Sol-Gel-Prozess in diese Feststoffteilchen umgewandelt werden, ausgewählt, wobei SiO₂-Partikel und/oder Vorstufen von SiO₂-Partikeln, welche über den Sol-Gel-Prozess in nanoskalige SiO₂-Partikel umgewandelt werden, besonders bevorzugt sind.

Die erfindungsgemäß bevorzugten Nanokomposite und deren Herstellung nach dem Sol-Gel-Verfahren sind im Stand der Technik bekannt, insbesondere aus DE 103 26 815 A1. Hierbei ist es bevorzugt, dass die nanoskaligen Feststoffteilchen mit einem Oberflächenmodifizierungsmittel mit einem Molekulargewicht von weniger als 1.500 oberflächenmodifiziert sind, insbesondere einem Oberflächenmodifizierungsmittel, das eine Anhydridgruppe, Säureamidgruppe, Aminogruppe, SiOH-Gruppe, hydrolysierbare Reste von Silanen und/oder eine β-Dicarbonylgruppe enthält.

Vorzugsweise ist das Nanokomposit erhältlich nach dem Sol-Gel-Verfahren durch Umsetzen von nanoskaligen Feststoffteilchen mit einem oder mehreren Silanen der allgemeinen Formel:

RₓSiA₍₄₋ₓ₎ (I)

worin die Reste A gleich oder verschieden sind und Hydroxylgruppen oder hydrolysierbare Gruppen darstellen, die Reste R gleich oder verschieden sind und nichthydrolysierbare Gruppen darstellen und x den Wert 0, 1, 2 oder 3 hat, wobei bei mindestens 50% der Stoffmenge der Silane x ≥ 1 ist. Sofern nur Silane der Formel (I) mit x=0 verwendet werden, gelangt man zu rein anorganischen Nanokompositen, ansonsten werden die bevorzugten organisch-anorganischen Nanokomposite erhalten.

Geeignete Beispiele von Silanen der obigen Formel (I) sind ebenfalls in der DE 103 26 815 A1 aufgeführt.

Insbesondere werden die erfindungsgemäßen Beschichtungen aus alkoholischen SiO₂-bildenden Solen, in denen hochreine Siliciumnitrid-Pulver dispergiert werden, hergestellt. Da Siliciumnitrid in Gegenwart von Wasser zur Hydrolyse neigt, sollten keine wasserbasierten Formulierungen eingesetzt werden, vielmehr sind alkoholische SiO₂-bildende Sole bevorzugt. Ferner ist die Verwendung hochreiner Ausgangschemikalien (Siliciumnitrid-Pulver, Silane, Alkohole, etc.) bevorzugt, da hierbei höchstreine Schichten erhalten werden können, die insbesondere den Anforderungen der Solarindustrie gerecht werden.

Bei den erfindungsgemäßen Formkörpern besteht das Substrat geeigneterweise aus Quarz, Graphit, Keramik (einschließlich Siliciumnitrid-Keramik), SiO₂ (fused silica) oder einer Eisenlegierung. Bei einer bevorzugten Ausführungsform handelt es sich bei dem Formkörper um einen Schmelztiegel mit einem Substrat aus Quarz, Graphit oder Keramik, welcher sich für die Verarbeitung korrosiver Nichteisenmetallschmelzen, insbesondere Siliciumschmelzen eignet.

Das Verfahren zur Herstellung eines erfindungsgemäßen Formkörpers umfasst mindestens die folgenden Schritte
Auftragen der erfindungsgemäßen Schlichte auf das Substrat durch ein- oder mehrmaliges Rakeln, Tauchen, Fluten, Schleudern, Sprühen, Bürsten oder Streichen,
Härten der aufgetragenen Schlichte zur Ausbildung einer dauerhaften Hartbeschichtung auf dem Substrat.

Zur Verbesserung der Haftung kann es in manchen Fällen vorteilhaft sein, das Substrat vor dem Kontaktieren mit verdünnten oder unverdünnten Bindemittelsolen bzw. deren Vorstufen oder anderen Primern zu behandeln.

Der Feststoffgehalt der Schlichten kann in Abhängigkeit vom gewählten Beschichtungsverfahren durch Zugabe von Lösungsmittel eingestellt werden. Für eine Sprühbeschichtung wird gewöhnlich ein Feststoffgehalt von 2 bis 70 Gew.-%, vorzugsweise 5 bis 50 Gew.-% und besonders bevorzugt von 10 bis 30 Gew.-%, eingestellt.

Der abschließenden Härtung können eine oder mehrere Trocknungsstufen bei Raumtemperatur oder leicht erhöhter Temperatur, beispielsweise in einem Umlufttrockenschrank und/oder durch Beheizung der Formkörper selbst vorangehen. Bei oxidationsempfindlichen Substraten kann die Trocknung und/oder nachfolgende Härtung in einer Schutzgasatmosphäre, beispielsweise in N₂ oder Ar oder im Vakuum erfolgen.

Die thermische Aushärtung erfolgt unter Berücksichtigung der Wärmeempfindlichkeit, vorzugsweise durch Wärmebehandlung bei Temperaturen über 50°C, vorzugsweise über 200°C und besonders bevorzugt über 300°C. Die Schichten können auch bei höheren Temperaturen ausgeheizt werden, bevorzugt bei Temperaturen von 500 bis 700°C, vorausgesetzt das Substrat ist bei diesen Temperaturen ausreichend stabil.

Bei einer weiteren Ausführungsform der Erfindung können die Schichten auch als Mehrfachschichten erzeugt werden.

Bei einer weiteren Ausführungsform der Erfindung können Gradientenschichten ausgebildet werden, wobei die Art und Reinheit der verwendeten Siliciumnitrid-Partikel beispielsweise von unten (substratseitig) nach oben (schmelzseitig) variieren kann. Hierbei können hinsichtlich Reinheit, Partikelgröße oder Partikelmorphologie unterschiedliche Siliciumnitrid-Qualitäten innerhalb des Schichtaufbaus verwendet werden. Weiterhin können in die Gradientenschichten auch unterschiedliche Bindergehalte eingebracht werden. Diese Gradientenschichten können auch als Mehrfachschichten erzeugt und angeordnet werden.

Die erfindungsgemäßen Formkörper mit den dauerhaften Hartbeschichtungen eignen sich auf dem Gebiet der korrosiven Nichteisenmetallschmelzen, wie Schmelzen von Aluminium, Glas, Silicium und dergleichen. Formkörper in Form von Schmelztiegeln eignen sich insbesondere zur Herstellung von Siliciumschmelzen, zur Aufnahme von flüssigem Silicium und zur Kristallisation von flüssigem Silicium zu Siliciumblöcken.

Die nachfolgenden Beispiele erläutern die Erfindung.

### Vergleichsbeispiel: Standardsuspension

Hierbei handelt es sich um eine gemäß EP 963 464 hergestellte Suspension von Siliciumnitrid-Pulver in dest. Wasser ohne weitere Zusätze.

Für die weitere Verarbeitung (Pinseln, Rollen, Sprühen) ist nur die Rheologie dieser Suspension Ausschlag gebend. Dementsprechend wird der Feststoffgehalt eingestellt, beispielsweise 60-70 Gew.-% für die Applikation mittels Sprühpistole.

Die Suspension wird auf den gereinigten, staubfreien, trockenen Tiegel ggf. in mehreren Schichten aufgebracht, um eine homogene Schichtdicke von beispielsweise 500-800 µm zu erzeugen. Nach Trocknung wird die Beschichtung vor dem Einsatz als Schmelztiegel bei ca. 1000-1100°C eingebrannt.

Die erhaltene Siliciumnitrid-Pulverbeschichtung sollte blasen- und rissfrei sein und auch keine anderen Defekte aufweisen.

Die so hergestellte Siliciumnitrid-Schicht ist nur bedingt berührungsfest und sollte entsprechend sorgsam behandelt werden. Nicht nur beim Beladen mit stückigem Si muss eine Verletzung der Beschichtung vermieden werden, sondern die Beladung muss auch selber dermaßen erfolgen, dass beim Erschmelzen das Verrutschen von stückigem Si vermieden wird, damit hier ebenfalls keine Defekte in der Pulverschicht erzeugt werden.

### Beispiel 1: Siliciumnitrid-Hardcoating

Für eine erfindungsgemäße Ausführung der Siliciumnitrid-Suspension wird eine Dispersion von 60 Gew.-% Siliciumnitrid-Pulver in Ethanol (wasserfrei) hergestellt. Hierzu kann sowohl das Pulver vorgelegt werden und das Dispergiermedium kontinuierlich eingearbeitet werden, als auch das Pulver in die vorgelegte Menge Ethanol eingerührt werden.

Zur ethanolischen Siliciumnitrid-Dispersion wird unter Rühren zu gleichen Teilen der Binder (Type ino^{®}sil S-38, Fa. Inomat GmbH) gegeben (auch umgekehrt möglich), um eine 30 Gew.-% Siliciumnitrid-haltige, sprühfähige Suspension herzustellen.

Die Suspension wird über Sprühen appliziert, wobei mehrere Lagen "naß in naß" zu Schichtdicken bis ca. 40 µm aufgebracht werden. Nach dem "Ablüften" bei Raumtemperatur, wird die Beschichtung im Trockenschrank getrocknet und anschließend bei 500°C für 30 min eingebrannt.

Der beschichtete Tiegel kann jetzt dem Schmelzprozess zugeführt werden. Der erhaltene, defektfreie Si-Ingot lässt sich problemlos entformen.

### Beispiel 2: Siliciumnitrid-Hardcoating

Für eine weitere erfindungsgemäße Ausführung der Siliciumnitrid-Suspension wird eine Dispersion von 60 Gew.-% Siliciumnitrid-Pulver in Ethanol (wasserfrei) hergestellt. Hierzu kann sowohl das Pulver vorgelegt werden und das Dispergiermedium kontinuierlich eingearbeitet werden, als auch das Pulver in die vorgelegte Menge Ethanol eingerührt werden.

Zur ethanolischen Siliciumnitrid-Dispersion wird unter Rühren der Binder (Type ino^{®}sil S-38, Fa. Inomat GmbH) im Verhältnis Siliciumnitrid:Binder 2:1 gegeben, um eine 40 Gew.-% Siliciumnitrid-haltige Suspension herzustellen.

Die höherviskose Suspension wird über dip-coating, Ausgießen oder Pinseln/Rollen appliziert, wobei Schichtdicken bis ca. 100 µm aufgebracht werden.

Nach dem "Ablüften" bei Raumtemperatur, wird die Beschichtung im Trockenschrank getrocknet und anschließend bei 500°C für 30 min eingebrannt.

Der beschichtete Tiegel kann jetzt dem Schmelzprozess zugeführt werden. Der defektfreie Si-Ingot lässt sich anschließend problemlos entformen.

### Beispiel 3: Siliciumnitrid-Hardcoating

Für eine weitere erfindungsgemäße Ausführung der Siliciumnitrid-Suspension zur Beschichtung von Solar-Tiegeln wird eine Suspension mit 30 Gew.-% Siliciumnitrid-Pulver direkt im flüssigen, ethanolischen Binder hergestellt. Hierzu wird das Siliciumnitrid-Pulver kontinuierlich in den Binder (Type ino^{®}sil S-38, Fa. Inomat GmbH) unter Rühren eingearbeitet. Zur Homogenisierung wird die Mischung für mehrere Stunden auf dem Rollenbock behandelt.

Die so erhaltene, agglomeratfreie 30 Gew.-% Siliciumnitrid-Suspension wird über Sprühen appliziert, wobei mehrere Lagen "naß in naß" zu Schichtdicken bis ca. 40 µm aufgebracht werden. Nach dem "Ablüften" bei Raumtemperatur, wird die Beschichtung im Trockenschrank getrocknet und anschließend bei 500°C für 30 min eingebrannt.

Der beschichtete Tiegel kann jetzt dem Schmelzprozess zugeführt werden. Der defektfreie Si-Ingot lässt sich problemlos entformen.

### Beispiel 4: Siliciumnitrid-Hardcoating

Für eine weitere erfindungsgemäße Ausführung der Siliciumnitrid-Suspension zur Beschichtung von Solar-Tiegeln wird eine Suspension mit 60 Gew.-% Siliciumnitrid-Pulver direkt im flüssigen, ethanolischen Binder hergestellt. Hierzu wird das Siliciumnitrid-Pulver kontinuierlich in den Binder (Type ino^{®}sil S-38, Fa. Inomat GmbH) unter Rühren eingearbeitet. Alternativ kann auch der Binder portionsweise in das vorgelegte Siliciumnitrid-Pulver eingearbeitet werden. Zur Homogenisierung wird die Mischung für mehrere Stunden auf dem Rollenbock behandelt.

Die so erhaltene, agglomeratfreie 60 Gew.-% Siliciumnitrid-Suspension wird über Pinseln und Rollen appliziert, wobei Schichtdicken bis ca. 100 µm aufgebracht werden. Nach dem "Ablüften" bei Raumtemperatur, wird die Beschichtung im Trockenschrank getrocknet und anschließend bei 500°C für 30 min eingebrannt.

Der beschichtete Tiegel kann jetzt dem Schmelzprozess zugeführt werden. Der defektfreie Si-Ingot lässt sich problemlos entformen.

Die in den Beispielen beschriebenen Ausführungen der erfindungsgemäßen Siliciumnitrid-Beschichtungen unterscheiden sich von der Referenzbeschichtung nach dem Stand der Technik durch ihre geringere Schichtdicken. Trotz der geringeren Schichtdicken werden immer funktionelle, d.h. defektfreie (blasen-, rissfrei) Trennschichten erzeugt. Durch den enthaltenen Binder weisen diese Schichten gegenüber der standardmäßigen Siliciumnitrid-Pulverbeschichtung deutlich höhere Haft- und Kratzfestigkeiten auf. Trotz der dünneren Beschichtung werden die Schichten beim Beladen oder/und Erschmelzen des stückigen Si nicht beschädigt, so dass der Kontakt zwischen Schmelze und Tiegel, der beim Erstarren zur Anhaftung und damit zu Abplatzungen und Rissen führt, vermieden wird.

Die beschriebenen, erfindungsgemäßen Siliciumnitrid-Beschichtungen unterscheiden sich im Feststoffgehalt, dem Siliciumnitrid:Binder-Verhältnis und den Schichtdicken und dementsprechend in der Viskosität der Suspension, die die Applikationstechnik der Suspension bedingt bzw. den erzielbaren, defektfreien Schichten: Je höher das Siliciumnitrid:Binder-Verhältnis, desto dickere Schichten; je niedriger das Siliciumnitrid:Binder-Verhältnis, desto härter/kratzfester.

In Abhängigkeit vom jeweiligen Schmelz-/Solar-Si-Herstellungsprozess kann somit das optimale Beschichtungssystem eingestellt werden (Anpassung an Suspensionsherstellung, an Beschichtungsprozess und an jeweiligen Schmelzprozess).

## Patentansprüche

1. Schlichte zur Herstellung einer dauerhaften Hartbeschichtung auf einem Substrat, umfassend
a) Siliciumnitrid-Partikel, und
b) ein Bindemittel, umfassend nanoskalige Feststoffpartikel oder Vorstufen von nanoskaligen Feststoffpartikeln, welche über den Sol-Gel-Prozess in diese Feststoffpartikel umgewandelt werden, wobei das Bindemittel ein Nanokomposit aus den nanoskaligen Feststoffteilchen in einem organisch modifizierten anorganischen Polykondensat oder einer Vorstufe davon umfasst.

2. Schlichte nach Anspruch 1, wobei das organisch modifizierte anorganische Polykondensat oder dessen Vorstufe ein organisch modifiziertes anorganisches Polysiloxan oder dessen Vorstufe ist.

3. Schlichte nach mindestens einem der vorangehenden Ansprüche, wobei die nanoskaligen Feststoffteilchen Metalloxidteilchen sind.

4. Schlichte nach mindestens einem der vorangehenden Ansprüche, wobei die nanoskaligen Feststoffteilchen aus SiO₂, TiO₂, ZrO₂, Al₂O₃, AIOOH, Y₂O₃, CeO₂, SnO₂, Eisenoxiden und/oder Ta₂O₅ oder aus Vorstufen dieser nanoskaligen Feststoffteilchen, welche über den Sol-Gel-Prozess in diese Feststoffteilchen umgewandelt werden, ausgewählt sind.

5. Schlichte nach mindestens einem der vorangehenden Ansprüche, wobei als nanoskalige Feststoffteilchen SiO₂-Partikel oder Vorstufen von SiO₂-Partikeln, welche über den Sol-Gel-Prozess in nanoskalige SiO₂-Partikel umgewandelt werden, enthalten sind.

6. Schlichte nach mindestens einem der vorangehenden Ansprüche, wobei die nanoskaligen Feststoffteilchen mit einem Oberflächenmodifizierungsmittel mit einem Molekulargewicht von weniger als 1.500 oberflächenmodifiziert sind.

7. Schlichte nach mindestens einem der vorangehenden Ansprüche, wobei die nanoskaligen Feststoffteilchen mit einem Oberflächenmodifizierungsmittel modifiziert sind, das eine Anhydridgruppe, Säureamidgruppe, Aminogruppe, SiOH-Gruppe, hydrolysierbare Reste von Silanen und/oder eine β-Dicarbonylgruppe enthält.

8. Schlichte nach mindestens einem der vorangehenden Ansprüche, wobei das Nanokomposit erhältlich ist nach dem Sol-Gel-Verfahren durch Umsetzen von nanoskaligen Feststoffteilchen mit einem oder mehreren Silanen der allgemeinen Formel (I):
RₓSiA₍₄₋ₓ₎ (I)
worin die Reste A gleich oder verschieden sind und Hydroxylgruppen oder hydrolysierbare Gruppen darstellen, die Reste R gleich oder verschieden sind und nichthydrolysierbare Gruppen darstellen und x den Wert 0, l, 2 oder 3 hat, wobei bei mindestens 50% der Stoffmenge der Silane x ≥ 1 ist.

9. Formkörper, umfassend ein Substrat mit einer dauerhaften Hartbeschichtung, wobei die Hartbeschichtung aus einer Schlichte gemäß mindestens einem der Ansprüche 1-8 hergestellt worden ist.

10. Formkörper nach Anspruch 9, wobei das Substrat aus Quarz, Graphit, Keramik, SiO₂ (fused silica) oder einer Eisenlegierung besteht.

11. Formkörper nach Anspruch 9 und/oder 10, bei dem es sich um einen Schmelztiegel mit einem Substrat aus Quarz, Graphit oder Keramik für korrosive Nichteisenmetallschmelzen handelt.

12. Verfahren zur Herstellung eines Formkörpers nach mindestens einem der Ansprüche 9-11, umfassend die Schritte
Auftragen der Schlichte auf das Substrat durch ein- oder mehrmaliges Rakeln, Tauchen, Fluten, Schleudern, Sprühen, Bürsten oder Streichen,
Härten der aufgetragenen Schlichte zur Ausbildung einer dauerhaften Hartbeschichtung auf dem Substrat.

13. Verwendung eines Formkörpers gemäß mindestens einem der Ansprüche 9-11 auf dem Gebiet der korrosiven Nichteisenmetallschmelzen.

14. Verwendung eines Schmelztiegels gemäß Anspruch 11 zur Herstellung von Siliciumschmelzen, zur Aufnahme von flüssigem Silicium und/oder zur Kristallisation von flüssigem Silicium zu Siliciumblöcken.

## Claims

1. Slip for producing a durable hard coating on a substrate, comprising
a) silicon nitride particles, and
b) a binder comprising nanosize solid particles or precursors of nanosize solid particles which by means of the sol-gel process are converted into said solid particles, wherein the binder comprises a nanocomposite comprising the nanosize solid particles in an organically modified inorganic polycondensate or a precursor thereof.

2. Slip according to Claim 1, wherein the organically modified inorganic polycondensate or precursor thereof is an organically modified inorganic polysiloxane or a precursor thereof.

3. Slip according to at least one of the preceding claims, wherein the nanosize solid particles are metal oxide particles.

4. Slip according to at least one of the preceding claims, wherein the nanosize solid particles are selected from among SiO₂, TiO₂, ZrO₂, Al₂O₃, AlOOH, Y₂O₃, CeO₂, SnO₂, iron oxides and Ta₂O₅ or among precursors of these nanosize solid particles which are converted by means of the sol-gel process into these solid particles.

5. Slip according to at least one of the preceding claims, wherein SiO₂ particles or precursors of SiO₂ particles which are converted by means of the sol-gel process into nanosize SiO₂ particles are present as nanosize solid particles.

6. Slip according to at least one of the preceding claims, wherein the nanosize solid particles have been surface-modified with a surface modifier having a molecular weight of less than 1500.

7. Slip according to at least one of the preceding claims, wherein the nanosize solid particles have been modified with a surface modifier containing an anhydride group, acid amide group, amino group, SiOH group, hydrolysable radicals of silanes and/or a β-dicarbonyl group.

8. Slip according to at least one of the preceding claims, wherein the nanocomposite is obtainable by the sol-gel process by reacting nanosize solid particles with one or more silanes of the general formula (I):
RₓSiA₍₄₋ₓ₎ (I)
where the radicals A are identical or different and are hydroxyl groups or hydrolysable groups, the radicals R are identical or different and are nonhydrolysable groups and x is 0, 1, 2 or 3, with x being ≥ 1 for at least 50% of the molar amount of the silanes.

9. Shaped body comprising a substrate having a durable hard coating, wherein the hard coating has been produced from a slip according to at least one of Claims 1-8.

10. Shaped body according to Claim 9, wherein the substrate comprises quartz, graphite, ceramic, SiO₂ (fused silica) or an iron alloy.

11. Shaped body according to Claim 9 and/or 10 which is a melting crucible having a substrate composed of quartz, graphite or ceramic for corrosive nonferrous metal melts.

12. Process for producing a shaped body according to at least one of Claims 9-11, comprising the steps:
application of the slip to the substrate by single or repeated doctor blade coating, dipping, flooding, spin coating, spraying, brushing or painting,
hardening of the applied slip to form a durable hard coating on the substrate.

13. Use of a shaped body according to at least one of Claims 9-11 in the field of corrosive nonferrous metal melts.

14. Use of a melting crucible according to Claim 11 for producing silicon melts, for accommodating liquid silicon and/or for crystallization of liquid silicon to produce silicon blocks.

## Revendications

1. Enduit destiné à produire un revêtement dur permanent sur un substrat, comprenant
a) des particules de nitrure de silicium et
b) un agent liant, comprenant des particules solides de l'ordre nanométrique ou des précurseurs de particules solides de l'ordre nanométrique que l'on transforme en lesdites particules solides via un processus sol-gel, l'agent liant comprenant un nano-composite constitué des particules solides de l'ordre nanométrique dans un polycondensat anorganique organiquement modifié ou dans un précurseur de celui-ci.

2. Enduit selon la revendication 1, le polycondensat anorganique organiquement modifié ou son précurseur étant un polysiloxane anorganique organiquement modifié ou son précurseur.

3. Enduit selon au moins l'une quelconque des revendications précédentes, les particules solides de l'ordre nanométrique étant des particules d'oxydes métalliques.

4. Enduit selon au moins l'une quelconque des revendications précédentes, les particules solides de l'ordre nanométrique étant choisies parmi le SiO₂, le TiO₂, le ZrO₂, l'Al₂O₃, l'AlOOH, le Y₂O₃, le CeO₂, le SnO₂, les oxydes de fer et/ou le Ta₂O₅ ou des précurseurs desdites particules solides de l'ordre nanométrique que l'on transforme en lesdites particules solides via le processus sol-gel.

5. Enduit selon au moins l'une quelconque des revendications précédentes, dans lequel sont contenus en tant que particules solides de l'ordre nanométrique des particules de SiO₂ ou des précurseurs de particules SiO₂ que l'on transforme en particules de SiO₂ de l'ordre nanométrique via le processus sol-gel.

6. Enduit selon au moins l'une quelconque des revendications précédentes, pour lequel on modifie la surface des particules solides de l'ordre nanométrique à l'aide d'un produit modificateur de surfaces d'un poids moléculaire inférieur à 1.500.

7. Enduit selon au moins l'une quelconque des revendications précédentes, dans lequel les particules solides de l'ordre nanométrique sont modifiées à l'aide d'un produit modificateur de surfaces qui contient un groupe anhydride, un groupe amide d'acide, un groupe amino, un groupe SiOH, des radicaux hydrolysables de silanes et/ou un groupe β-dicarbonyle.

8. Enduit selon au moins l'une quelconque des revendications précédentes, pour lequel le nano-composite peut être obtenu selon le procédé sol-gel, par transformation de particules solides avec un ou plusieurs silane(s) de la formule générale (I) :
RₓSiA₍₄₋ₓ₎ (I)
dans laquelle les radicaux A sont identiques ou différents et représentent des groupe hydroxyles ou des groupe hydrolysables et x a la valeur 0, 1, 2 ou 3, pour au moins 50 % de la quantité de substances, le silane étant ≥ 1.

9. Corps moulé comprenant un substrat doté d'un revêtement dur permanent, le revêtement dur ayant été produit à partir d'un enduit selon au moins l'une quelconque des revendications 1 à 8.

10. Corps moulé selon la revendication 9, le substrat étant constitué de quartz, de graphite, de céramique, de SiO₂ (silice fondue) ou d'un alliage de fer.

11. Corps moulé selon la revendication 9 et/ou 10, pour lequel il s'agit d'un creuset avec un substrat en quartz, en graphite ou en céramique pour des masses fondues corrosives en métal non ferreux.

12. Procédé destiné à la production d'un corps moulé selon au moins l'une quelconque des revendications 9 à 11, comprenant les étapes :
Application de l'enduit sur le substrat par enduction à la racle, immersion, aspersion, centrifugation, vaporisation, brossage ou enduction au pinceau unique ou répété(e),
Solidification de l'enduit appliqué pour la création d'un revêtement du permanent sur le substrat.

13. Utilisation d'un corps moulé, selon au moins l'une quelconque des revendications 9 à 11 dans le domaine des masses fondues corrosives en métaux non ferreux.

14. Utilisation d'un creuset selon la revendication 11 pour la fabrication de masses fondues en silicium, destinées à recevoir du silicium liquide et/ou à cristalliser du silicium liquide en blocs de silicium.
